# EUROPÄISCHE PATENTSCHRIFT

(11) **EP 2 924 759 B1**
(45) Veröffentlichungstag und Bekanntmachung des Hinweises auf die Patenterteilung: **03.07.2019**
(21) Anmeldenummer: 15161290.0
(22) Anmeldetag: 27.03.2015
(51) Int. Cl.: H01L 51/52

(54) **LEUCHTMODUL UND HERSTELLUNGSVERFAHREN FÜR EIN LEUCHTMODUL**
LIGHTING MODULE AND MANUFACTURING METHOD FOR A LIGHTING MODULE
MODULE D'ÉCLAIRAGE ET PROCÉDÉ DE FABRICATION D'UN MODULE D'ÉCLAIRAGE

(30) Priorität: 27.03.2014 DE 102014205747
(43) Veröffentlichungstag der Anmeldung: 30.09.2015
(73) Patentinhaber: Tridonic Dresden GmbH & Co. KG, 01109 Dresden (DE)
(72) Erfinder: Eritt, Michael, 01129 Dresden (DE); Hartwig, Melinda, 09111 Chemnitz (DE); Kirchhof, Christian, 01099 Dresden (DE)
(74) Vertreter: Banzer, Hans-Jörg

(56) Entgegenhaltungen:
- WO-A1-2009/115955
- WO-A1-2012/045857
- GB-A- 2 416 621
- US-A1- 2004 119 403
- US-A1- 2013 056 783

## Beschreibung

Die Erfindung betrifft Leuchtmodule, die wenigstens ein Flächenleuchtelement umfassen. Die Erfindung betrifft insbesondere Leuchtmodule, die ein Flächenleuchtelement auf Basis organischer Leuchtdioden (OLED, "Organic Light Emitting Diodes") oder Quantenpunkt-Leuchtdioden (QLED, "Quantum Dot Light Emitting Diodes") umfassen.

Auf der Basis von OLEDs oder QLEDs können neuartige Flächenlichtelemente verwirklicht werden. Als flächiger Leuchtkörper mit gegenüber einer herkömmlichen Halbleiter-Leuchtdiode (LED) moderater Leuchtdichte sind beispielsweise OLEDs gut geeignet für die Herstellung flächiger diffuser Lichtquellen. Insbesondere im professionellen Beleuchtungsbereich ist eine diffuse Beleuchtung eine neue Möglichkeit der Realisierung von großflächigen hochqualitativen Leuchten. Es wird in dieser Hinsicht auf den folgenden Stand der Technik in den Dokumenten US2013056783, GB2416621, WO2009115955, US2004119403 und WO2012045857 verwiesen.

Durch Einsatz von Dünnschichttechnologie können OLEDs oder QLEDs auch die Realisierung von flexiblen Leuchtkörpern ermöglichen, die vollkommen neue Anwendungen in der Beleuchtung von Räumen gestatten.

Die maximale Größe von derartigen Leuchtflächenelementen ist typischerweise beschränkt. Insbesondere wird durch die Anforderung begrenzt, eine weitgehend homogene Stromdichteverteilung unter Verwendung mindestens eines transparenten Kontaktes zu erreichen. Derartige Kontakte können beispielsweise durch transparent leitfähige Oxide (TCO, "Transparent Conductive Oxides") gebildet werden, deren Leitfähigkeit in Kombination mit der Anforderung einer homogenen Stromdichteverteilung die maximale Leuchtflächengröße limitiert.

Die Verschaltung mehrerer Module untereinander oder mit externen Verbindungsleitungen ist daher von Bedeutung. Durch eine Verschaltung mehrerer Module untereinander kann beispielsweise eine größere Leuchtfläche erzeugt werden.

Ein Flächenleuchtelement mit einem flexiblen, dünnen Trägersubstrat, das eine hohe Transmission aufweist, ist mit seinen Dünnschichtkontakten nur schwierig in zuverlässiger Weise zu kontaktieren. Nicht nur eine Verbindung zu anderen Flächenleuchtelementen, sondern auch eine einfache und robuste Verbindung zu einem Konverter kann schwierig zu realisieren sein. Darüber hinaus kann ein derartiges Flächenleuchtelement empfindlich gegenüber mechanischer Belastung und anfällig für eine Korrosion der nach außen offenliegenden Kontakte sein. Dies erschwert die Verarbeitung der Flächenleuchtelemente durch einen Leuchtenhersteller.

Der Erfindung liegt die Aufgabe zugrunde, Vorrichtungen und Verfahren anzugeben, die die Verarbeitung der Flächenleuchtelemente beispielsweise bei der Herstellung einer Leuchte erleichtern. Der Erfindung liegt insbesondere die Aufgabe zugrunde, derartige Vorrichtungen und Verfahren anzugeben, die die Kontaktierung von Flächenleuchtelementen erleichtern und die Anfälligkeit gegenüber mechanischen oder anderen Beeinträchtigungen verringern.

Nach Beispielen der Erfindung wird ein Flächenleuchtelement, das ein OLED-Flächenleuchtelement oder ein QLED-Flächenleuchtelement sein kann, in ein Modul integriert, das einen mehrlagigen Aufbau aufweist. Ein oder mehrere Folien können auf das Flächenleuchtelement auflaminiert sein. Eine Folie kann auf einer Rückseite und eine weitere Folie auf einer Frontseite des Flächenleuchtelements vorhanden sein. Ein Kontaktierungselement mit leitenden Strukturen kann zwischen einer der Folien und dem Flächenleuchtelement angeordnet sein. Das Kontaktierungselement kann ein Verdrahtungsträger sein, der aus einem leitenden Material, beispielsweise einem Metall, besteht oder an dem leitende Strukturen angebracht sind.

Das Kontaktierungselement kann eine elektrische Verbindung zwischen dem Flächenleuchtelement und einem Konverter oder zu einem anderen Flächenleuchtelement erleichtern. Durch die Folien kann die Anfälligkeit des Flächenleuchtelements gegenüber mechanischen Einflüssen oder einer Korrosion von Elektroden des Flächenleuchtelements verringert werden.

Die vorliegende Erfindung betrifft ein Leuchtmodul mit einem mehrlagigen Aufbau gemäß dem Hauptanspruch 1. Die weitere Folie kann an einer Frontseite des Flächenleuchtelements angebracht sein.

Die Folie und die weitere Folie können die Hauptflächen des Flächenleuchtelements im Wesentlichen überdecken und Schutz gegen Umwelteinflüsse bieten. Darüber hinaus kann wenigstens eine der auf der Vorder- und Rückseite angebrachten Folien das Kontaktierungselement zwischen sich und dem Flächenleuchtelement halten.

Die Folie, die weitere Folie, das Kontaktierungselement und das Flächenleuchtelement können einen formschlüssigen Verbund bilden.

Das Flächenleuchtelement kann flexibel sein. Das Flächenleuchtelement kann ein Trägersubstrat aus Dünnglas mit einer Dicke von ≤ 50 µm oder aus einer Polymerfolie mit einer Dicke von ≤ 300 µm umfassen.

Der Verdrahtungsträger kann flexibel sein.

Das Leuchtmodul kann ein flexibles Leuchtmodul sein.

Die Folie und/oder die weitere Folie kann wenigstens eine Funktionsbeschichtung aufweisen.

An der an der Frontseite des Flächenleuchtelements angebrachten Folie und/oder an der an der Rückseite des Flächenleuchtelements angebrachten Folie kann eine Funktionsbeschichtung als Kratzschutz aufgebracht sein.

Zusätzlich oder alternativ kann an der an der Frontseite des Flächenleuchtelements angebrachten Folie eine Funktionsbeschichtung als Antireflexbeschichtung aufgebracht sein.

Zusätzlich oder alternativ kann an der an der Frontseite des Flächenleuchtelements angebrachten Folie eine Funktionsbeschichtung zur Verbesserung der optischen Auskopplung aufgebracht sein.

Zusätzlich oder alternativ kann an der an der Rückseite des Flächenleuchtelements angebrachten Folie eine Wärmeleitschicht als Funktionsbeschichtung aufgebracht sein.

Zusätzlich oder alternativ kann an der an der Rückseite des Flächenleuchtelements angebrachten Folie ein Klebefilm zur einfacheren Installation als Funktionsbeschichtung aufgebracht sein.

Die Funktionsbeschichtung kann jeweils an der vom Flächenleuchtelement weg zeigenden äußeren Oberfläche der entsprechenden Folie aufgebracht sein.

Die Folie und/oder die weitere Folie können eine Öffnung oder mehrere Öffnungen zum Kontaktieren des Flächenleuchtelements umfassen. Die Öffnungen können an einer Rückseite des Flächenleuchtelements ausgebildet sein, um zu ermöglichen, dass eine Kontaktierung und Befestigung von derselben Seite aus erfolgen. Die Öffnungen können an einer Frontseite des Flächenleuchtelements ausgebildet sein, um eine einfache Kontaktierung der Elektroden des Flächenleuchtelements von der Frontseite aus zu ermöglichen.

Das Kontaktierungselement kann zum Anschließen wenigstens eines elektrisch leitenden Verbindungselements seitlich über die Folie hervorragen.

Das Kontaktierungselement kann für eine Verbindung zu einem Konverter mit einem Steck- oder Lötkontakt ausgebildet sein.

Das Kontaktierungselement kann so dimensioniert sein, dass wenigstens ein Abschnitt des Kontaktierungselements seitlich über das Flächenleuchtelement herausragt. Auch dieser Abschnitt des Kontaktierungselements kann noch zwischen der Folie und der weiteren Folie angeordnet sein oder kann auch von diesen seitlich hervorstehen.

Das Flächenleuchtelement kann eine Elektrodenfläche umfassen, mit der das Kontaktierungselement durch einen elektrisch leitenden Klebstoff verbunden ist.

Das Kontaktierungselement kann durch einen Dünnschichtprozess oder einen Dickschichtprozess auf die Folie aufgebracht sein. Das Kontaktierungselement kann unmittelbar auf die Folie oder auf einen flächig an der Folie vorgesehenen Klebstofffilm aufgebracht sein.

Das Kontaktierungselement kann auf einem auf der Folie vorgesehenen flächigen Klebstofffilm aufgebracht sein.

Das Kontaktierungselement kann aus einer Paste oder Tinte bestehen, die vor einer Lamination oder während einer Lamination konditioniert wird.

Das Leuchtmodul kann in einem Laminationsprozess hergestellt werden. Die Folie und die weitere Folie können an das Flächenleuchtelement anlaminiert sein. Optional können weitere Schichten, wie eine Abdeckschicht, ebenfalls durch den Laminationsprozess in das Leuchtmodul integriert werden.

Das Leuchtmodul kann wenigstens eine Abdeckschicht zum Abdecken nicht Licht emittierender Bereiche des Leuchtmoduls umfassen.

Das Leuchtmodul kann nicht nur ein, sondern mehrere Flächenleuchtelemente umfassen, die zwischen der Folie und der weiteren Folie angeordnet sein können. Die mehreren Flächenleuchtelemente können seitlich nebeneinander angeordnet sein. Das Kontaktierungselement mit den Leitungsstrukturen kann eine elektrische Verbindung zwischen den mehreren Flächenleuchtelementen herstellen, um diese in einer Reihenschaltung zu verbinden. Das Kontaktierungselement kann einen Anodenkontakt eines Flächenleuchtelements mit einer Kathodenkontakt eines weiteren Flächenleuchtelements verbinden.

Das Kontaktierungselement kann eingerichtet sein, um die mehrere Flächenleuchtelemente, die zwischen der Folie und der weiteren Folie angeordnet sind, in eine Mehrzahl von Reihenschaltungen zu verbinden. Dies erleichtert einen Betrieb mit Spannungen im SELV ("Separated Extra Low Voltage")-Bereich. Es können ein oder mehrere Öffnungen in einer der Folien vorhanden sein, um eine Kontaktierung der Mehrzahl von Reihenschaltungen zu erlauben.

Das Leuchtmodul kann ein flexibles Leuchtmodul sein.

Das Flächenleuchtelement kann ein Trägersubstrat, eine aktive lichtemittierende Struktur, die als OLED oder QLED-Struktur ausgebildet ist, und eine Verkapselung umfassen, wobei die aktive lichtemittierende Struktur zwischen dem Trägersubstrat und der Verkapselung angeordnet ist. Elektrodenkontakte für eine Anode und eine Kathode können so an dem Flächenleuchtelement angebracht sein, dass sie vor der Verkapselung des Flächenleuchtelements frei zugänglich sind. Die Elektrodenkontakte können aus einer metallischen oder metalloxidischen Schicht bestehen.

Ein System nach einem Ausführungsbeispiel kann ein Leuchtmodul nach einem Ausführungsbeispiel und einen Konverter umfassen. Ein Ausgang des Konverters kann elektrisch leitend mit wenigstens einer Leitungsstruktur des Kontaktierungselements verbunden sein. Die leitende Struktur des Kontaktierungselements kann durch eine Steckverbindung oder eine Lötverbindung mit dem Konverter verbunden sein.

Bei einem Verfahren zur Herstellung eines Leuchtmoduls nach einem Ausführungsbeispiel wird wenigstens eine Folie an ein OLED-Flächenleuchtelement oder ein QLED-Flächenleuchtelement laminiert.

Das mit dem Verfahren hergestellte Leuchtmodul kann ein Leuchtmodul nach einem Ausführungsbeispiel sein.

Bei dem Verfahren kann die Folie so an das Flächenleuchtelement laminiert werden, dass wenigstens ein Abschnitt eines Kontaktierungselements zwischen der Folie und dem Flächenleuchtelement angeordnet ist.

Das Verfahren kann ein Verbinden des Kontaktierungselements mit einer Elektrodenfläche des Flächenleuchtelements durch einen elektrisch leitenden Klebstoff umfassen.

Das Kontaktierungselement kann vor dem Laminieren auf die Folie aufgebracht werden. Das Kontaktierungselement kann unmittelbar oder indirekt über einen auf der Folie vorgesehenen flächigen Klebstofffilm auf die Folie aufgebracht werden.

Das Kontaktierungselement kann durch einen Dünnschichtprozess direkt auf die Folie oder auf einen flächig an der Folie vorgesehenen Klebstofffilm aufgebracht werden.

Das Kontaktierungselement kann durch einen Dickschichtprozess direkt auf die Folie oder auf einen flächig an der Folie vorgesehenen Klebstofffilm aufgebracht werden.

Das Verfahren kann ein Konditionieren einer leitfähigen Paste oder Tinte zum Formen des Kontaktierungselements umfassen.

Die leitfähige Paste oder Tinte kann vor dem Laminieren konditioniert werden.

Die leitfähige Paste oder Tinte kann während des Laminierens konditioniert werden.

Die Folie und eine weitere Folie können gleichzeitig an das Flächenleuchtelement laminiert werden. Das Laminieren kann durch eine Plattenlamination oder eine Rollenlamination an das Flächenleuchtelement laminiert werden.

Es können mehrere Flächenleuchtelemente zwischen zwei Folien einlaminiert werden. Das Kontaktierungselement kann die Flächenleuchtelemente in einer Reihenschaltung verbinden. Das Kontaktierungselement kann auch segmentweise so ausgebildet sein, dass es jeweils Gruppen von einer vorbestimmten Anzahl von Flächenleuchtelementen miteinander verbinden. Öffnungen in einer der Folien können eine Kontaktierung der Reihenschaltungen von Flächenleuchtelementen ermöglichen.

Vorrichtungen und Verfahren nach Ausführungsbeispielen können insbesondere für Beleuchtungssysteme verwendet werden, bei denen eine flächige Beleuchtung gewünscht wird.

Weitere Merkmale, Vorteile und Funktionen von Ausführungsbeispielen der Erfindung werden aus der nachfolgenden detaillierten Beschreibung anhand der beigefügten Zeichnungen ersichtlich, in denen gleiche oder ähnliche Bezugszeichen Einheiten mit gleicher oder ähnlicher Funktion bezeichnen.
Figur 1 zeigt eine Explosionsansicht eines Leuchtmoduls nach einem Ausführungsbeispiel im Querschnitt zur Erläuterung des mehrlagigen Aufbaus.
Figur 2 zeigt einen Querschnitt eines Flächenleuchtelements, das bei Leuchtmodulen nach Ausführungsbeispielen verwendet werden kann.
Figur 3 zeigt eine Draufsicht eines Flächenleuchtelements, das bei Leuchtmodulen nach Ausführungsbeispielen verwendet werden kann.
Figur 4 ist eine Querschnittsansicht des Leuchtmoduls von Figur 1.
Figur 5 ist eine Querschnittsansicht eines Leuchtmoduls nach einem weiteren Ausführungsbeispiel.
Figur 6 ist eine Explosionsansicht eines Leuchtmoduls nach einem weiteren Ausführungsbeispiel im Querschnitt.
Figur 7 zeigt Draufsichten von Leuchtmodulen nach Ausführungsbeispielen.
Figur 8 ist eine vergrößerte teilweise Querschnittsansicht eines Leuchtmoduls nach einem Ausführungsbeispiel, das mehrere Flächenleuchtelemente umfasst.
Figur 9 zeigt Draufsichten von Leuchtmodulen nach Ausführungsbeispielen, die mehrere Flächenleuchtelemente umfassen.
Figur 10 zeigt eine Draufsichten eines Leuchtmoduls nach einem Ausführungsbeispiel, das mehrere Flächenleuchtelemente umfasst.
Figur 11 zeigt eine Draufsichten eines Leuchtmoduls nach einem Ausführungsbeispiel, das mehrere Flächenleuchtelemente umfasst.
Figur 12 zeigt eine Explosionsansicht eines Leuchtmoduls nach einem Ausführungsbeispiel im Querschnitt.
Figur 13 zeigt eine Draufsicht auf ein Kontaktierungselement bei einem Leuchtmodul nach einem Ausführungsbeispiel.
Figur 14 zeigt eine Explosionsansicht eines Leuchtmoduls nach einem Ausführungsbeispiel im Querschnitt.
Figur 15 zeigt eine Explosionsansicht eines Leuchtmoduls nach einem Ausführungsbeispiel im Querschnitt.
Figur 16 zeigt eine Explosionsansicht eines Leuchtmoduls nach einem Ausführungsbeispiel im Querschnitt.
Figur 17 zeigt eine Explosionsansicht eines Leuchtmoduls nach einem Ausführungsbeispiel im Querschnitt.
Figur 18 ist eine Darstellung einer Leuchte mit einem Leuchtmodul nach einem Ausführungsbeispiel, das in einer Querschnittsansicht dargestellt ist.

Während im Kontext von Ausführungsbeispielen auf Flächenleuchtelements Bezug genommen wird, die OLED-Panels sein können, sollte es sich verstehen, dass die beschriebenen Ausführungsbeispiele auch auf andere Flächenleuchtelemente, beispielsweise QLED-Panels, angewendet werden können.

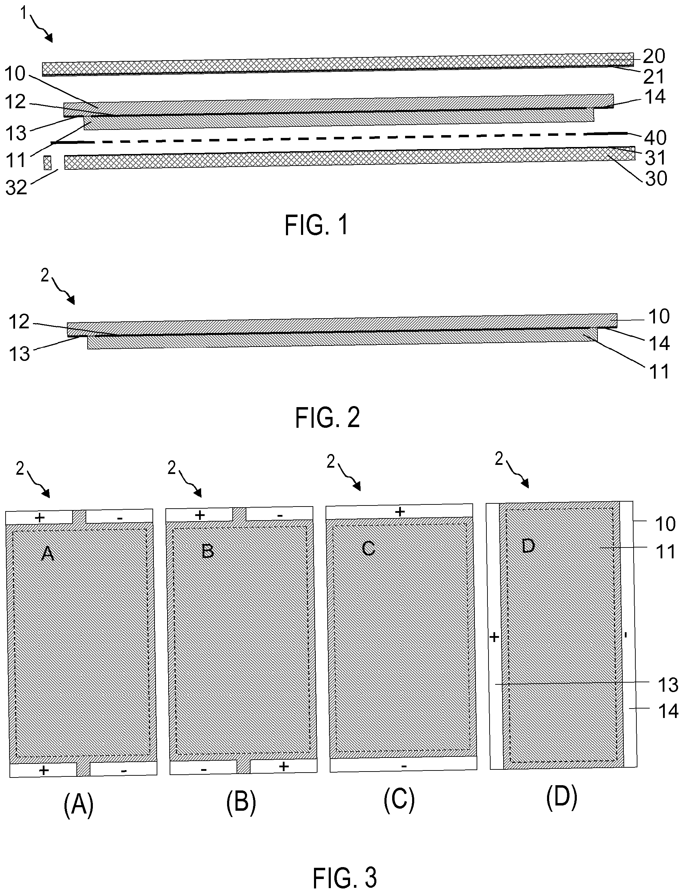

Figur 1 ist eine Explosionsansicht eines Leuchtmoduls 1 nach einem Ausführungsbeispiel im Schnitt zur Erläuterung des mehrlagigen Aufbaus. Das Leuchtmodul umfasst ein Flächenleuchtelement 2, das in Figur 2 noch einmal separat dargestellt ist. Das Flächenleuchtelement 2 kann ein flexibles OLED-Panel oder QLED-Panel sein.

Figur 2 zeigt deutlicher den Aufbau eines Flächenleuchtelements 2, das in dem Leuchtmodul 1 mit Folien 20, 30 und einem Kontaktierungselement, das ein Verdrahtungsträger 40 sein kann, in einem Verbundkörper verbunden ist. Das Flächenleuchtelement 2 umfasst ein Trägersubstrat 10 mit einer aufgebrachten aktiven OLED- oder QLED-Struktur 12. Das Trägersubstrat 10 kann aus Dünnglas bestehen. Das Dünnglas kann eine Dicke von ≤ 50 µm aufweisen. Das Trägersubstrat 10 kann aus einer Polymerfolie, beispielsweise Polyethylenterephthalat (PET), Polyethylen-naphthalat (PEN), Polycarbonat (PC), Polymethylmethacrylat (PMM) bestehen. Die Polymerfolie weist beispielsweise eine Dicke zwischen ca. 50 und 300 µm auf.

Das Flächenleuchtelement 2 umfasst eine Verkapselung 11 der aktiven Schicht 12, die die aktiven Schicht 12 oder die aktiven Schichten 12 vor Umwelteinflüssen schützt. Das Flächenleuchtelement 2 umfasst Kontakte für Anode 13 und Kathode 14, die an den Rändern des Flächenleuchtelements dargestellt sind und die frei zugänglich sind. Die Kontakte für die Anode 13 und für die Kathode 14 können aus einer metallischen oder metalloxidischen Schicht oder einer Legierung aus diesen bestehen. Als Kontaktmaterialen für die Kontakte 13, 14 können Aluminium, Silber, Molybdän, ITO oder Legierungen oder Schichtsysteme aus diesen verwendet werden. Die Kontakte 13, 14 für die Anode und die Kathode können auf unterschiedliche Weise an dem Flächenleuchtelement angeordnet sein. Beispielsweise können Anodenkontakte an beiden gegenüberliegenden Seiten des Flächenleuchtelements 2 angeordnet sein, und Kathodenkontakte können an denselben gegenüberliegenden Seiten des Flächenleuchtelements 2 angeordnet sein. Ein Anodenkontakt kann an nur einer Seite und der Kathodenkontakt an der gegenüberliegenden Seite des Flächenleuchtelements angeordnet sein. Die Seiten können die kurzen Seiten oder die langen Seiten des Flächenleuchtelements 2 sein. Verschiedene mögliche Anordnungen von Elektrodenkontakten sind in Figur 3 schematisch dargestellt.

Figur 3 zeigt unterschiedliche Bauformen von Flächenleuchtelementen 2, die bei Leuchtmodulen 1 nach Ausführungsbeispielen verwendet werden können. Dabei ist zwischen den Elektrodenanschlüssen und deren Belegung zu unterscheiden, wobei in Figur 3 die Belegung ebenfalls dargestellt ist.

In Figur 3A ist ein Flächenleuchtelement 2, beispielsweise ein OLED-Panel, mit zweiseitiger Kontaktierung von Anode 13 (+) und Kathode 14 (-) an den Querseiten dargestellt. Die Kathode und Anode können jeweils einer Längsseite lokalisiert sein. Das Trägersubstrat 10 und die Verkapslung 11 sind ebenfalls gezeigt.

In Figur 3B ist ein Flächenleuchtelement 2, beispielsweise ein OLED-Panel, mit zweiseitiger Kontaktierung von Anode 13 (+) und Kathode 14 (-) an den Querseiten dargestellt, ähnlich zu Figur 3A, wobei jedoch die Anode und die Kathode alternierend derart angeordnet sind, so dass ein Anodenkontakt jeweils einem Kathodenkontakt gegenüberliegt.

In Figur 3C ist ein Flächenleuchtelement 2 dargestellt, bei dem an einer Querseite nur ein Kathodenkontakt angeordnet ist und an der anderen Querseite nur ein Kathodenkontakt angeordnet ist.

In Figur 3D ist ein Flächenleuchtelement 2 dargestellt, bei dem an einer Längsseite nur ein Kathodenkontakt angeordnet ist und an der anderen Längsseite nur ein Kathodenkontakt angeordnet ist.

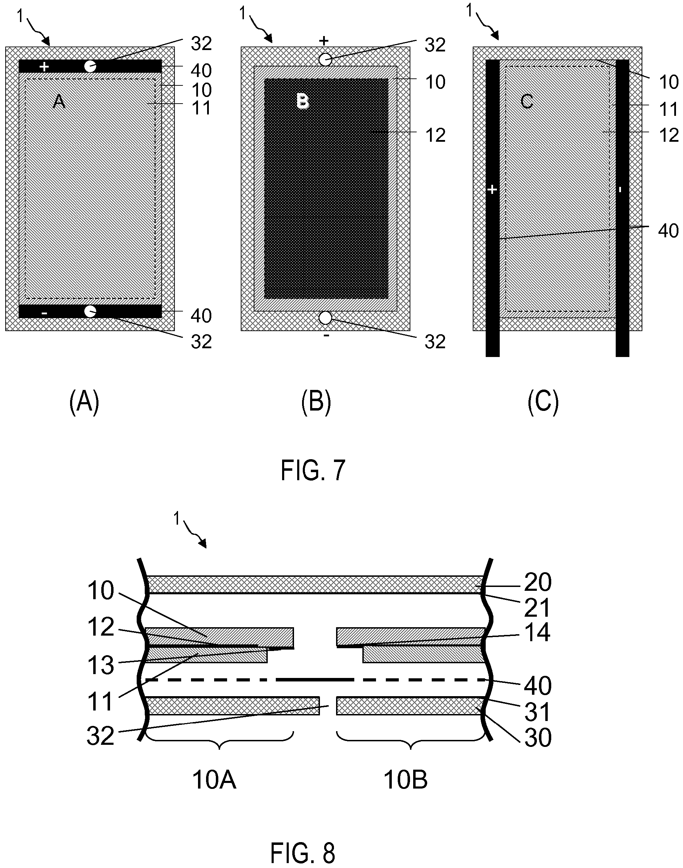

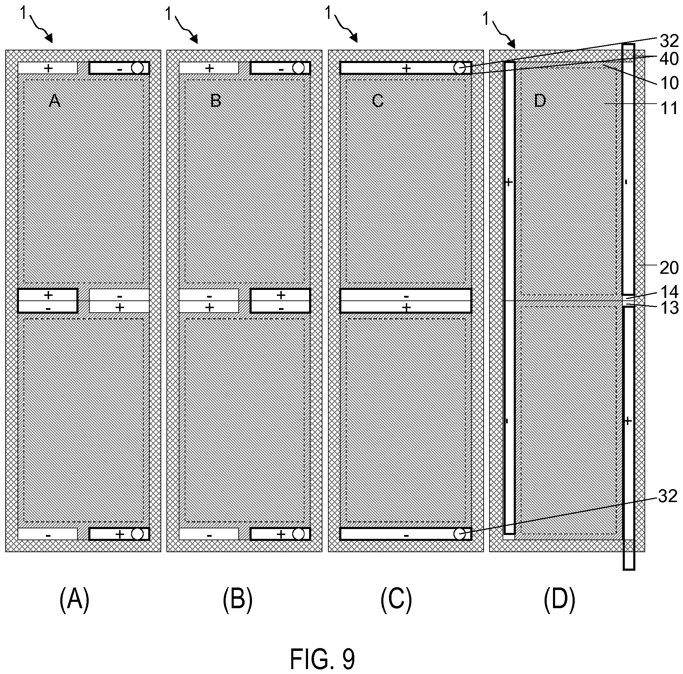

Unter erneuter Bezugnahme auf Figur 1 wird das Flächenleuchtelement 2 zur einfacheren Kontaktierung und zur Verbesserung der Beständigkeit gegenüber Umwelteinflüssen in einen Verbundkörper integriert, der zusätzlich zu dem Flächenleuchtelement 2 wenigstens eine Folie 20, 30 und einen Verdrahtungsträger 40 umfasst. Der Verdrahtungsträger 40 kann leitende Strukturen umfassen. Der Verdrahtungsträger 40 kann aus einem leitenden Material bestehen, beispielsweise aus einem Metall oder einer Metalllegierung. Der Verdrahtungsträger 40 kann ein metallischer Verdrahtungsträger sein. Der Verdrahtungsträger 40 kann auch in mehrere Abschnitte segmentiert sein, wie unter Bezugnahme auf Figur 8 und Figur 9 noch näher beschrieben werden wird.

Bei dem in Figur 1 dargestellten Leuchtmodul 1 weist der Verbundkörper zwei Folien 20, 30 auf, nämlich eine Frontfolie 20 auf der Frontseite des Flächenleuchtelements 2 und eine Rückseitenfolie 30 auf einer Rückseite des Flächenleuchtelements 2. Der Verdrahtungsträger 40 liegt innen.

In dem Leuchtmodul 2 kann der Verdrahtungsträger 40 rein mechanisch mit dem Anodenkotakt und/oder dem Kathodenkontakt verbunden sein. Der Verdrahtungsträger 40 kann mittels eines auf dem Verdrahtungsträger zum Anodenkontakt und/oder Kathodenkontakt hin aufgebrachten elektrisch leitfähigen Klebstoff in elektrisch leitenden Kontakt mit dem Anodenkontakt und/oder dem Kathodenkontakt gebracht werden. Der elektrisch leitfähige Klebstoff kann dabei ganzflächig oder selektiv an den Kontaktstellen auf dem Verdrahtungsträger 40 aufgebracht sein.

Die Frontfolie 20 und die Rückseitenfolie 30 können aus einem flexiblen Material wie z.B. PET, PEN, PC, PMMA oder Dünnglas bestehen. Die Dicke der Frontfolie 30 und die Rückseitenfolie 30 kann zwischen 50 und 500 µm liegen. Eine Frontfolie oder Rückseitenfolie mit größerer oder kleinerer Dicke kann ebenfalls verwendet werden. Wenigstens die Frontfolie 20 kann aus einem Material bestehen, das in dem Wellenlängenbereich, in dem die aktive Schicht 12 des Flächenleuchtelements 2 Licht emittiert, eine hohe Transmission aufweist. Wenigstens die Frontfolie 20 kann aus einem Material bestehen, das im sichtbaren Wellenlängenbereich eine hohe Transmission aufweist.

Optional kann ein Klebstofffilm 21, 31 zur Verbindung der Folien mit dem Flächenleuchtelement verwendet werden. Der Klebstofffilm 21, 31 kann bei einem Laminiervorgang auch als separater Klebefilm eingelegt werden. Es kann ein thermoplastischer Klebstofffilm 21, 31 oder ein Acrylat oder vergleichbarer Klebstoff verwendet werden, der thermisch oder mittels Druck oder Flächenkontakt aktiviert wird oder seine Klebeeigenschaften zeigt.

Die Frontfolie 20 und die Rückseitenfolie 30 haben verschiedene Eigenschaften und Wirkungen im Verbundkörper des Leuchtmoduls 2. Beispielsweise können beide Folien dem mechanischen Schutz des integrierten Flächenleuchtelements 2 und dem Schutz der Kontaktierung 13, 14 vor Umwelteinflüssen dienen. Die Rückseitenfolie 30 kann eine Öffnung 32 aufweisen, die eine Kontaktierung zum Verdrahtungsträger 40 von außen ermöglicht. Für die Ansteuerung einer OLED sind mindestens 2 Kontakte für die Anoden- bzw. Kathodenkontaktierung erforderlich. Die Rückseitenfolie 30 kann eine Öffnung 32 aufweisen, durch die sowohl die Anodenkontaktierung als auch die Kathodenkontaktierung erfolgt, oder kann mehrere Öffnungen 32 für diesen Zweck aufweisen.

Der Verdrahtungsträger 40 kann so eingerichtet sein, dass er durch die Öffnung 32, die ein Durchbruch in der Rückseitenfolie 30 ist, über eine Klemmverbindung, eine Steckverbindung, eine Lötverbindung, eine Klebeverbindung oder einer Kombination daraus mit der Zuleitung zum Konverter verbunden werden kann. Der Verdrahtungsträger 40 kann Anschlusselemente für eine Klemmverbindung oder eine Steckverbindung aufweisen.

Die Öffnung 32 oder die Öffnungen 32 müssen nicht unbedingt in der Rückseitenfolie vorgesehen sein, sondern können alternativ oder zusätzlich auch in der Frontfolie 20 vorhanden sein, um eine Kontaktierung des Verdrahtungsträgers und somit des Leuchtmoduls 1 mit dem Flächenleuchtelement 2 von der Frontseite zu ermöglichen.

Die Herstellung des Verbundkörpers derart, dass die Frontfolie 20 und die Rückseitenfolie 30 flächig mit dem Flächenleuchtelement 2 verbunden werden, kann durch einen Laminationsprozess erfolgen. Es kann ein Plattenlaminationsprozess oder ein Rollenlaminationsprozess ausgeführt werden. Bei beiden Verfahren entsteht durch Druckeinwirkung und/oder Temperatureinwirkung ein formschlüssiger Verbund.

Bei einer Plattenlamination erfolgt die Lamination in einem Plattenlaminator, wie er herkömmlich beispielsweise in der Solarmodulherstellung verwendet werden kann, bei der die Solarzellen zwischen zwei Gläser einlaminiert werden. Zur Herstellung des Verbundkörpers können die in Figur 1 dargestellten Komponenten auf eine beheizbare Platte gelegt werden. Ein Zwischenraum kann auf einen Druck von ca. 100 mbar oder weniger evakuiert werden. Mittels einer aufliegenden Membran wird der Verbund durch den Atmosphärendruck zusammengedrückt. Die Platte wird dabei temperiert und somit eine thermische Aktivierung bzw. ein Aufschmelzen des Klebstoffes hervorgerufen, der den Verbund verschmelzen lässt.

Der Plattenlaminationsprozess ermöglicht, längere Temperaturkurven zu fahren und dabei auch den Druck zu variieren. Dieser Prozess ist typischerweise für eine Verwendung zur Herstellung einer kleineren Anzahl von Leuchtmodulen geeignet. Der Prozess kann mehrere Minuten bis Stunden dauern.

Bei einem Rollenlaminationsprozess erfolgt die Lamination zwischen mindestens zwei Rollen, die beheizt werden und mittels Druck mindestens zwei Folien miteinander verbinden. Hierbei ist es möglich, die Frontfolie 20 und die Rückfolie 30 von der Rolle zuzuführen. Auch zusätzliche Folien (beispielsweise der Verdrahtungsträger, Klebefilme, Funktionsbeschichtungen) können dabei zugeführt werden. Mehrere Flächenleuchtelemente können nacheinander eingelegt und einlaminiert werden. Der Prozess hat ein engeres Prozessfenster für Temperatur bzw. Druckvariation als der Plattenlaminator. Allerdings kann bei geeigneten Materialien der Laminationsprozess schneller ausgeführt werden als eine Plattenlamination. Darüber hinaus können Leuchtmodule großer Länge hergestellt werden. Dazu können mehrere, beispielsweise mehrere zehn oder auch mehrere hundert Flächenleuchtelemente nacheinander in den Rollenlaminator eingelegt und zwischen zwei Folien einlaminiert werden. Reihenschaltungen von Flächenleuchtelementen können durch den Verdrahtungsträger erzeugt werden.

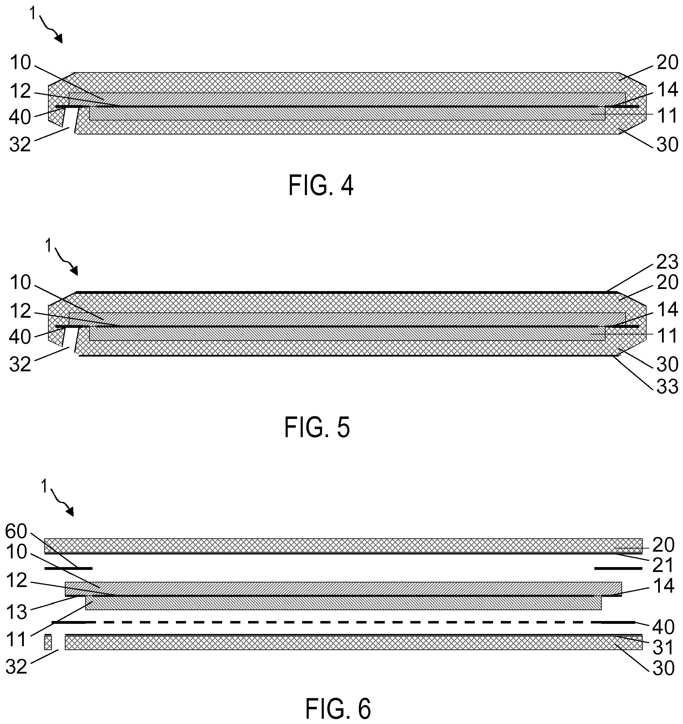

Figur 4 zeigt das Leuchtmodul 1, wie es durch den Laminationsprozess erzeugt wird. Das Leuchtmodul ist ein formschlüssiger Verbund aus dem Flächenleuchtelement 2, dem metallischen Verdrahtungsträger 40, der Frontfolie 20 und der Rückseitenfolie 30.

In dem Leuchtmodul 1 sind der Anodenkontakt 13 und der Kathodenkontakt 14 eingekapselt durch die Rückseitenfolie 30. Der Anodenkontakt 13 und der Kathodenkontakt sind durch den Verdrahtungsträger 40 elektrisch leitend kontaktiert.

In dem Leuchtmodul 1 ist das Flächenleuchtelement 2 von den beiden Folien 20, 30 umschlossen und so besser vor Umwelteinflüssen geschützt. Dadurch lässt sich bei geeigneter Barrierewirkung dieser Folien das Flächenleuchtelement 2 zusätzlich ein Schutz gegen das Eindringen von Wasser, Staub und/oder Sauerstoff erreichen.

Figur 5 zeigt ein Leuchtmodul 1 nach einem weiteren Ausführungsbeispiel. Dabei werden ein oder mehrere zusätzliche Beschichtungen 23, 33 auf die Frontfolie 20 und/oder die Rückseitenfolie 30 aufgebracht. Die Beschichtung bzw. die Beschichtungen können beim Laminieren aufgebracht werden. Die Beschichtungen 23, 33 können als Dünnschichtsysteme, als Dickschichtsysteme oder Foliensysteme auf Frontfolie 20 und/oder die Rückfolie 30 beschichtet werden.

Unterschiedliche Ausgestaltungen der Funktionsbeschichtungen können gewählt werden. Es kann Kratzschutz als Funktionsschicht auf die Frontfolie 20 und/oder die Rückseitenfolie 30 aufgebracht sein. Zusätzlich oder alternativ kann eine Antireflexbeschichtung auf die Frontfolie 20 als Funktionsschicht aufgebracht sein. Zusätzlich oder alternativ kann eine Schicht zur Auskopplungsverbesserung auf die Frontfolie 20 als Funktionsschicht aufgebracht sein. Zusätzlich oder alternativ kann eine Wärmeleitschicht auf der Rückseitenfolie 30 zur Abfuhr der Wärme als Funktionsschicht aufgebracht sein. Zusätzlich oder alternativ kann ein Klebefilm zum einfachen Installieren in einer Leuchte auf der Rückseitenfolie 30 als Funktionsschicht aufgebracht sein.

Beliebige Kombinationen der genannten Funktionsschichten können verwendet werden.

Figur 6 zeigt ein Leuchtmodul 1 nach einem weiteren Ausführungsbeispiel. Bei dem Leuchtmodul 1 ist eine Zusatzfolie 60 zwischen die Frontfolie 20 und das Trägersubstrat 10 des Flächenleuchtelements 2 eingelegt. Die Zusatzfolie 60 ist hierbei im Bereich der Lichtemission 12 transparent oder freigestellt, im restlichen Bereich blickdicht oder lichtdicht.

Die Zusatzfolie 60 kann eine Farbe aufweisen, die an die Anwendung angepasst werden kann, in der das Leuchtmodul 1 verwendet wird. Beispielsweise kann ihre Farbe dem Erscheinungsbild der Leuchtfläche des Flächenleuchtelements 2 im ausgeschalteten Zustand oder der Umgebung, in die das Modul integriert werden soll (z.B. Farbe der Leuchte, der Wand, der Decke, etc.), entsprechen. Somit ergibt sich im an- und ausgeschalteten Zustand der OLED ein homogenes Erscheinungsbild.

Ein auf der zum Trägersubstrat 10 gerichteten Seite der Zusatzfolie 60 aufgebrachter oder eingelegter Klebefilm verbindet das Trägersubstrat 10 und die Zusatzfolie 60, die als Kaschierungsfolie wirkt. Je nach Material kann ein thermoplastischer Klebstofffilm oder ein Acrylat oder vergleichbarer Klebstoff, der thermisch oder mittels Druck oder Flächenkontakt aktiviert wird und seine Klebeeigenschaften zeigt, verwendet werden.

Als Alternative oder zusätzlich zur Verwendung einer Kaschierungsfolie 60 kann die Frontfolie 20 auf einer Frontseite und/oder Rückseite selektiv in denjenigen Bereichen blickdicht oder lichtdicht bedruckt werden, die nicht Licht emittierende Bereiche des Flächenleuchtelements 2 überdecken. Die Frontfolie 60 kann an allen Flächen außer dem Bereich, der der senkrechten Projektion der aktiven Schicht 12 auf die Frontfolie 20 entspricht, blick- oder lichtdicht bedruckt sein. Das Folienmaterial kann in diesen Bereichen selektiv durchfärbt sein.

Mit derartigen Ausgestaltungen kann verhindert werden, dass das Kontaktierungselement in seinen seitlich über das Trägersubstrat 10 herausragenden Abschnitten von der Frontseite aus sichtbar ist.

Figur 7 zeigt beispielhaft verschiedene Ausgestaltungen, mit denen das Kontaktierungselement 40 die Kontaktierung der Flächenleuchtelemente erleichtert.

Figur 7A zeigt eine Draufsicht auf eine Rückseite des Leuchtmoduls 1, wobei die Öffnungen 32 in der Rückseitenfolie 30 ausgebildet sind. Der Verdrahtungsträger 40 befindet sich auf den Elektrodenkontakten des Flächenleuchtelements 2, so dass er auf der Rückseite der aktiven Schicht angeordnet ist. Das Flächenleuchtelement in Figur 7A kann eine Anordnung von Elektrodenkontakten aufweisen, wie sie in Figur 3C dargestellt ist. Die Öffnungen 32 zum Kontaktieren des Flächenleuchtelements 2 zum Anschluss an einen Konverter sind von der Rückseite zugänglich. Dies hat den Vorteil, dass die Befestigung und die Kontaktierung von einer Seite erfolgt, was für die nahtlose Aufsatzmontage (so genannte "surface mount"-Technik) von Vorteil ist, z.B. auf Oberflächen an Wand und Decke mit versteckt dahinter verlaufender elektrischer und mechanischer Versorgung des Moduls.

Figur 7B zeigt eine Draufsicht auf eine Frontseite des Leuchtmoduls 1, wobei die Öffnungen 32 in der Frontfolie 20 ausgebildet sind. Der Verdrahtungsträger 40 befindet sich auf den Elektrodenkontakten des Flächenleuchtelements 2. Das Flächenleuchtelement 2 des Leuchtmoduls 1 von Figur 7B kann eine Anordnung von Elektrodenkontakten aufweisen, wie sie in Figur 3C dargestellt ist. Die Öffnungen 32 zur Kontaktierung der Elektroden in der Frontfolie 20 vorhanden. Dieser Aufbau ermöglicht die einfache elektrische Kontaktierung des Flächenleuchtelements nach der Montage. Dies kann insbesondere bei Anwendungen von Vorteil sein, bei denen die Anschlusskontakte separat durch eine Blende in der Leuchte abgedeckt werden.

Figur 7C zeigt eine Draufsicht auf eine Rückseite des Leuchtmoduls 1, wobei die Öffnungen 32 in der Rückseitenfolie 30 ausgebildet sind. Der Verdrahtungsträger 40 befindet sich auf den Elektrodenkontakten des Flächenleuchtelements 2, so dass er auf der Rückseite der aktiven Schicht angeordnet ist. Das Flächenleuchtelement in Figur 7A kann eine Anordnung von Elektrodenkontakten aufweisen, wie sie in Figur 3D dargestellt ist. Bei dem Leuchtmodul 1 von Figur 7C wird der Verdrahtungsträger 40 für beide Elektrodenkontakte zur Seite aus dem Modul herausgeführt und kann dort über Klemm-, Steck-, Löt- oder Klebeverbindungen oder einer Kombination daraus mit der Zuleitung zum Konverter verbunden werden.

Die Ausgestaltung des Leuchtmoduls 1 nach Ausführungsbeispielen hat weiterhin den Vorteil, dass nicht nur ein, sondern auch mehrere Flächenleuchtelemente zwischen dieselben Folien eingelegt und durch dieselben Folien verkapselt sein können. Das Kontaktierungselement, das zwischen eine Folie und die Flächenleuchtelemente eingelegt ist, kann die Verbindungen zwischen den Kontakten der Flächenleuchtelemente herstellen.

Das Kontaktierungselement kann so segmentiert sein, dass es die Flächenleuchtelemente in mehreren Reihenschaltungen verschaltet. Jede der Reihenschaltungen kann dabei aus einer Anzahl von Flächenleuchtelementen bestehen, die so gewählt ist, dass die Vorwärtsspannung jeder der Reihenschaltungen im SELV-Bereich liegt, also beispielsweise kleiner als 75 Volt DC (Gleichspannung) sein kann.

In dem Leuchtmodul können die mehrere Flächenleuchtelemente in Ketten oder in zweidimensionalen Anordnungen miteinander leitend verbunden sein. Dadurch ist die einfache Installation inklusive der elektrischen Kontaktierung und Ansteuerung des Verbundes möglich.

Die Verbindung der einzelnen Flächenleuchtelemente im Modulverbund erfolgt über den metallischen Verdrahtungsträger. Hierbei kann eine Serienverschaltung der einzelnen Flächenleuchtelemente durch Aneinanderreihung und Verbindung der Anoden mit den Kathoden erfolgen. Die äußersten Kontaktelektroden der Serienschaltung werden extern kontaktiert. Dazu können entsprechende Öffnungen in der Rückseitenfolie 30 oder der Frontfolie 20 vorhanden sein, die einen Anschluss an Leitungen zum Konverter erlauben.

Derartige Ausgestaltungen ermöglichen den Betrieb mehrerer Flächenleuchtelemente im Leuchtmodul durch einen Konverter mit gleichzeitig einfacher Verkabelung, da nur die äußersten Elektrodenkontakte der Reihenschaltung an den Konverter angeschlossen werden müssen. Der zum Betrieb notwendige Strom ist bei dieser Beschaltung konstant für unterschiedliche Anzahlen von Panels im Modul. Die Spannung einer Reihenschaltung erhöht sich auf U_{modul} = Uₚₐₙₑₗ×n, wobei Uₚₐₙₑₗ die Betriebsspannung eines Flächenleuchtelements, n die Anzahl der Flächenleuchtelemente in Reihe im Leuchtmodul und U_{modul} die resultierende Betriebsspannung für die Reihenschaltung ist. Flächenleuchtelemente, die als OLED-Panels ausgestaltet sind, haben typischerweise Betriebsspannungen im Bereich von 3 - 10 V, weshalb nicht beliebige Anzahlen von OLED Panels verschalten werden können, um im Kleinspannungsbereich (beispielsweise im SELV-Bereich von bis zu 75 V) zu bleiben. Die abschnittsweise Gestaltung des Verdrahtungsträgers derart, dass er in Segmente segmentiert ist, und das Einfügen von Kontaktöffnungen vor und nach diesen Abschnitten des Verdrahtungsträgers ermöglicht die Beschaltung einer größeren Anzahl von Flächenleuchtelementen im Leuchtmodul 1.

Figur 8 zeigt einen Ausschnitt der Queransicht eines Leuchtmoduls 1 nach einem Ausführungsbeispiel in einem explodierten Zustand, wie er vor der Lamination vorliegt. Das Leuchtmodul 1 weist mehrere Flächenleuchtelemente auf, wie sie durch die Bereiche 10A und 10B dargestellt sind. Die mehreren Flächenleuchtelemente können jeweils denselben Aufbau aufweisen. Die mehreren Flächenleuchtelemente können wie unter Bezugnahme auf Figur 2 beschrieben ausgestaltet sein. Die Flächenleuchtelemente können in anstoßendem Kontakt aneinander anliegen oder können mit einem vordefinierten Abstand zueinander im Leuchtmodul angeordnet sein, wie dies in Figur 8 dargestellt ist. Bei der nahtlosen Aneinanderreihung kann ein großer Füllgrad und damit ein kleiner nichtleuchtender Bereich zwischen den Flächenleuchtelementen im Modul erreicht werden.

Das Kontaktierungselement, beispielsweise ein metallischer Verdrahtungsträger 40, verbindet einen Anodenkontakt 13 eines ersten Flächenleuchtelements 10A mit einem Kathodenkontakt 14 eines zweiten Flächenleuchtelements 10B. Optional kann eine Öffnung 32 in der Rückseitenfolie 30 vorgesehen sein, über die das Kontaktierungselement von außen zugänglich ist.

Die mehreren Flächenleuchtelemente sind bei einem Leuchtmodul, wie es in Figur 8 dargestellt ist, zwischen denselben Folien einlaminiert.

Mehrere Flächenleuchtelemente können auf eine Vielzahl unterschiedlicher Weisen miteinander in einem Leuchtmodul kombiniert werden.

Figur 9 zeigt beispielhaft vier Ausgestaltungen von Leuchtmodulen, die jeweils mehrere Flächenleuchtelemente aufweisen. Die unterschiedlichen Flächenleuchtelemente können jeweils eine identische Ausgestaltung aufweisen. Die in Figur 9 dargestellten Ausgestaltungen können um weitere Flächenleuchtmodule erweitert werden.

Das Leuchtmodul 1 von Figur 9A weist zwei Flächenleuchtelemente mit einer Ausgestaltung auf, wie sie in Figur 3A dargestellt ist. Die Flächenleuchtelemente sind so angeordnet, dass benachbarte Flächenleuchtelemente jeweils um 180° relativ zueinander gedreht sind. Beispielsweise können die ungeraden Flächenleuchtelemente eine erste Orientierung aufweisen und die geraden Panels können um 180° relativ zu der ersten Orientierung um eine Achse senkrecht zur Ebene der aktiven Schicht 12 gedreht sein, damit sich Anoden- bzw. Kathodenkontakte alternierend gegenüberliegen. Der Verdrahtungsträger 40 verbindet alternierend die Anoden- und Kathodenkontakte und sorgt über Durchbrüche 32 für die Kontaktierung nach außen zum Konverter.

Das Leuchtmodul 1 von Figur 9B weist zwei Flächenleuchtelemente mit einer Ausgestaltung auf, wie sie in Figur 3B dargestellt ist. Die Flächenleuchtelemente sind so angeordnet sind, dass sie dieselbe Orientierung aufweisen. Der Verdrahtungsträger 40 dient für eine Kontaktierung nach außen. Der Verdrahtungsträger 40 kann den Kathodenkontakt eines Flächenleuchtelements mit dem Anodenkontakt eines weiteren Flächenleuchtelements leitend verbinden.

Das Leuchtmodul 1 von Figur 9C weist zwei Flächenleuchtelemente mit einer Ausgestaltung auf, wie sie in Figur 3C dargestellt ist. Die Flächenleuchtelemente sind so angeordnet, dass sie dieselbe Orientierung aufweisen. Der Verdrahtungsträger 40 dient für eine Kontaktierung nach außen. Der Verdrahtungsträger 40 kann den Kathodenkontakt eines Flächenleuchtelements mit dem Kathodenkontakt eines weiteren Flächenleuchtelements leitend verbinden.

Das Leuchtmodul 1 von Figur 9D weist zwei Flächenleuchtelemente mit einer Ausgestaltung auf, wie sie in Figur 3D dargestellt ist. Die Flächenleuchtelemente sind so angeordnet, dass benachbarte Flächenleuchtelemente jeweils um 180° relativ zueinander gedreht sind. Beispielsweise können die ungeraden Flächenleuchtelemente eine erste Orientierung aufweisen und die geraden Panels können um 180° relativ zu der ersten Orientierung um eine Achse senkrecht zur Ebene der aktiven Schicht 12 gedreht sein, damit sich Anoden- bzw. Kathodenkontakte alternierend gegenüberliegen. Der Verdrahtungsträger 40 verbindet alternierend die Anoden- und Kathodenkontakte. Der Verdrahtungsträger 40 steht auf beiden Seiten über die Flächenleuchtelemente, um einen Anschluss an den Konverter zu erleichtern.

Bei weiteren Abwandlungen kann der Verdrahtungsträger 40 in Figur 9A, Figur 9B und Figur 9C ähnlich wie in Figur 9D dargestellt durch Überstände aus dem Modul nach außen herausgeführt werden. Die Öffnungen 32 können dann weggelassen werden. Bei der Ausgestaltung von Figur 9D ist auch eine Kontaktierung nach außen unter Verwendung von Öffnungen 32 möglich.

Die unterschiedlichen Flächenleuchtelemente können im Leuchtmodul so nebeneinander angeordnet sein, dass sich die Reihe von Flächenleuchtelementen parallel zu einer Längsseite der Flächenleuchtelemente erstreckt. Die unterschiedlichen Flächenleuchtelemente können im Leuchtmodul so nebeneinander angeordnet sein, dass sich die Reihe von Flächenleuchtelementen parallel zu einer Querseite der Flächenleuchtelemente erstreckt. Auch eine Matrixverschaltung in einer zweidimensionalen Anordnung, d.h. in x- und y-Richtung, ist möglich. Hierbei kann jeder Strang in x- oder y-Richtung Serienverschalten sein und in y- bzw. x-Richtung an einem separaten Strang/Kanal mit dem Konverter verbunden sein.

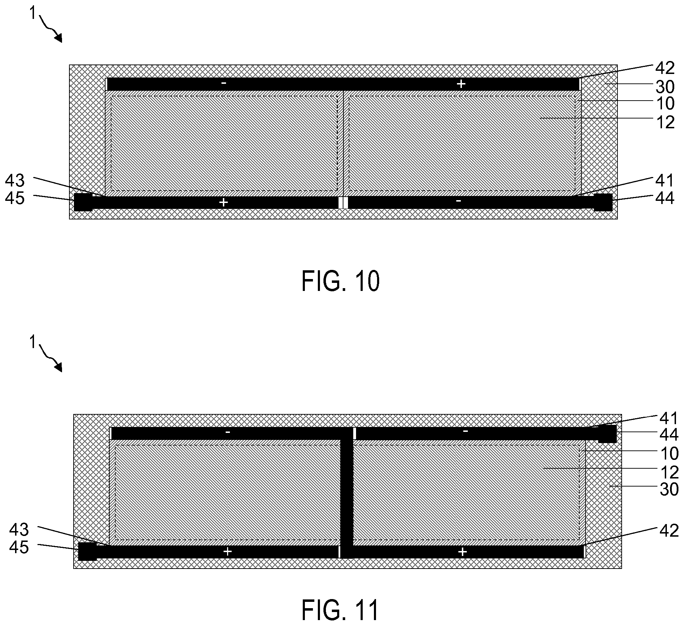

Figur 10 und Figur 11 zeigt jeweils ein Leuchtmodul 1 in Draufsicht zur weiteren Erläuterung von alternierenden und nicht alternierenden Elektrodenanordnungen. Bei der in Figur 10 dargestellten Anordnung von Flächenleuchtelementen in einem Leuchtmodul 1 erstrecken sich eine Anodenfläche eines Flächenleuchtelements und eine Kathodenfläche eines benachbarten Flächenleuchtelements entlang einer Linie. Anoden und Kathoden können alternierende angeordnet sein. Bei der in Figur 11 dargestellten Anordnung von Flächenleuchtelementen in einem Leuchtmodul 1 erstrecken sich eine Anodenfläche eines Flächenleuchtelements und eine Anodenfläche eines benachbarten Flächenleuchtelements entlang einer Linie. Die Anoden sind nicht-alternierend angeordnet. Dies gilt entsprechend für die Kathoden.

Bei der in Figur 10 dargestellten Ausgestaltung weist das Leuchtmodul 1 ein erstes Flächenleuchtelement und ein diesem benachbartes zweites Flächenleuchtelement auf. Die Flächenleuchtelemente können jeweils OLED-Panels sein. Das zweite Flächenleuchtelement kann um 180° relativ zu dem ersten Flächenleuchtelement gedreht angeordnet, so dass in einer Linie abwechselnd eine Kathode eines Flächenleuchtelements und eine Anode des benachbarten Flächenleuchtelements nebeneinander liegen.

Die Folie, die als Träger für das zur Verdrahtung verwendete Kontaktierungselement dient, kann eine leitfähige Struktur aufweisen, um das Kontaktierungselement zu bilden. Die leitfähige Struktur kann aus einer Metallschicht, einer Metalloxidschicht oder einer Kombination aus einer Metallschicht und einer Metalloxidschicht bestehen. Die leitfähige Struktur kann mittels eines Dünnschichtprozesses oder eines Dickschichtprozesses aufgebracht sein.

Die leitfähige Struktur kann gemäß den anzuschließenden Elektrodenflächen des ersten und des zweiten Leuchtmoduls unterschiedliche Abschnitte aufweisen. Die leitfähige Struktur des Kontaktierungselements kann einen nach außen geführten Anodeanschluss 43 aufweisen. Der Anodenanschluss 43 kann ein Anodenkontaktpad 45 aufweisen. Die leitfähige Struktur kann einen Kathodeanschluss 41 aufweisen. Der Kathodenanschluss 41 kann ein Kathodenkontaktpad 44 aufweisen. Ein Verbindungsleiter 42 der leitfähigen Struktur kann jeweils eine Anode eines Flächenleuchtelements mit einer Kathode eines anderen Flächenleuchtelements in dem Leuchtmodul verbinden.

Bei der in Figur 11 dargestellten Ausgestaltung weist das Leuchtmodul 1 ein erstes Flächenleuchtelement und ein diesem benachbartes zweites Flächenleuchtelement auf. Die Flächenleuchtelemente können jeweils OLED-Panels sein. Das erste Flächenleuchtelement und das zweite Flächenleuchtelement sind so angeordnet, dass eine Anodenfläche des ersten Flächenleuchtelements und eine Anodenfläche des zweiten Flächenleuchtelements sich entlang einer Linie erstrecken. Das erste Flächenleuchtelement und das zweite Flächenleuchtelement sind so angeordnet, dass eine Kathodenfläche des ersten Flächenleuchtelements und eine Kathodenfläche des zweiten Flächenleuchtelements sich entlang einer weiteren Linie erstrecken. Beispielsweise können die Anodenflächen jeweils an einer Seite der Flächenleuchtelemente angeordnet sein, und die Kathodenflächen können an der jeweils gegenüberliegenden Seite der Flächenleuchtelemente angeordnet sein. Die Verschaltung in Reihe erfolgt über die Verbindung von der Anode des ersten Flächenleuchtelements mit der Kathode des zweiten Flächenleuchtelements über einen Verbindungsleiter 42 des Kontaktierungselements 40. Der Anschluss des Verbundes erfolgt über das Anodenkontaktpad 45 und das Kathodenkontaktpad 44.

Auch wenn in Figur 9 bis Figur 11 beispielhaft Leuchtmodule 1 mit zwei Flächenleuchtelementen dargestellt sind, können Leuchtmodule nach Ausführungsbeispielen ein, zwei oder mehr als zwei Flächenleuchtelemente umfassen. Die Anordnung und Kontaktierung kann bei mehr als zwei Flächenleuchtelementen so erfolgen, dass die Elektrodenflächen der Flächenleuchtelemente alternierend angeordnet sind, wie dies beispielhaft in Figur 10 dargestellt ist, oder nicht alternierend angeordnet sind, wie dies beispielhaft in Figur 11 dargestellt ist.

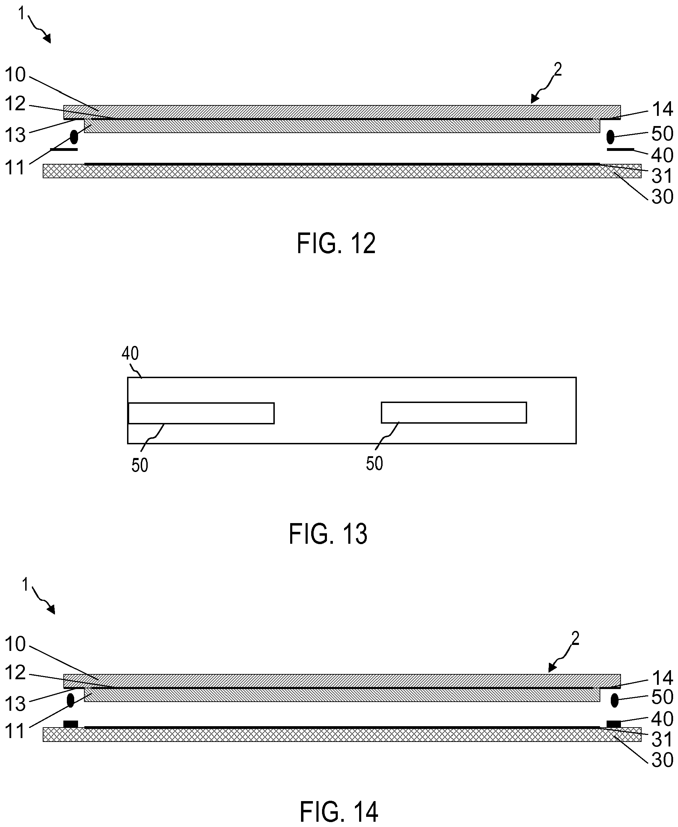

Eine robuste sowie elektrisch und/oder mechanisch stabile Ausführung der Kontaktierung der Flächenleuchtelemente durch das Kontaktierungselement, das den Verdrahtungsträger 40 umfassen kann, ist erwünscht, um die Funktion des Verbundes über die Lebensdauer zu gewährleisten. Verschiedene Ausgestaltungen des Aufbaus und der Herstellung werden unter Bezugnahme auf Figur 12 bis Figur 17 näher beschrieben.

Zur Herstellung der elektrischen Verbindung können die Elektrodenflächen 13, 14 des Flächenleuchtelements 10 niederohimg mit den Anodenanschlüssen 43 und/oder den Kathodenanschlüssen 41 des Kontaktierungselements 40 verbunden. Der Übergangswiderstand dieser elektrischen Verbindung zwischen Flächenleuchtelement 2 und Kontaktierungselement 40 kann folglich klein sein.

Verschiedene Techniken können zur Erhöhung der Stabilität der mechanischen Verbindung eingesetzt werden. Beispielswiese kann ein Klebstoff verwendet werden, um das Kontaktierungselement 40 und das Flächenleuchtelement 2 mechanisch zu verbinden. Es kann auch eine Klebstoffschicht 31 auf die Folie 30 aufgebracht sein, um die mechanische Verbindung zu verbessern. Die Klebstoffschicht kann aus einem thermisch aktivierbaren Klebstoff bestehen. Beispielsweise kann ein Acrylat eingesetzt werden, um die Klebstoffschicht 31 zu bilden.

Figur 12 zeigt ein Leuchtmodul 1 nach einem Ausführungsbeispiel in einer Explosionsdarstellung im Querschnitt. Auch wenn in Figur 12 nur ein Flächenleuchtelement mit einem Trägersubstrat 10, einer aktiven Schicht 12, einer Verkapselung 11 und Elektrodenflächen 13, 14 dargestellt ist, kann das Leuchtmodul 1 mehr als ein Flächenleuchtelement umfassen. Ein Träger 30 für das Leuchtmodul 1 kann durch eine Folie gebildet werden.

Zur mechanisch stabilen Verbindung zwischen dem Flächenleuchtelement 2 und der Folie 30, die als Träger dient, kann ein Klebstofffilm 31 vorgesehen sein. Der Klebstofffilm 31 kann sich entlang der Verkapselung 11 erstrecken. Der Klebstofffilm 31 kann so angeordnet sein, dass er sich im Verbund zwischen der Folie 30 und der Verkapselung 11 des Flächenleuchtelements 2 erstreckt. Der Klebstofffilm 31 kann auf der Folie 31 oder auf der Verkapselung 11 aufgebracht sein.

Das Kontaktierungselement 40, das als Verdrahtungsmaterial ausgeführt ist, kann bei der Herstellung als ein separates Element eingelegt werden. Das Kontaktierungselement 40 kann aus einem Metall, beispielsweise Kupfer, Aluminium oder einem anderen Metall, bestehen.

Das Kontaktierungselement 40 über einen leitenden Klebstoff 50 oder eine leitende Paste 50 elektrisch und mechanisch mit wenigstens einer Elektrodenfläche 13, 14 des Flächenleuchtelements 2 verbunden. Das Kontaktierungselement 40 kann durch den Klebstoff 50 elektrisch und mechanisch mit der Anodenfläche und der Kathodenfläche des Flächenleuchtelements 2 verbunden werden.

Der Klebstoff 50 oder die Paste 50 kann flächig auf das Kontaktierungselement 40 oder die Elektrodenflächen 13, 14 aufgebracht sein. Der Klebstoff 50 oder die Paste 50 kann derart gewählt sein, dass er auch im ausgehärteten Zustand eine Restflexibilität aufweist. Beispielsweise kann der Klebstoff 50 ein leitfähiger Klebstoff auf Silikonbasis sein. Das Leuchtmodul 1 kann dadurch auch dann, wenn es gebogen wird, elektrisch und mechanisch gute Stabilität aufweisen.

Es ist auch möglich, den Klebstoff 50 oder die Paste 50 punktuell oder strichförmig unterbrochen aufzubringen. Dies erlaubt es, eine größere Vielfalt von aushärtenden Klebstoffen oder Pasten 50 zu verwenden. Beispielsweise können Klebstoffe 50 auf Basis von Acrylaten verwendet werden. Die Flexibilität des Gesamtsystems wird durch die Unterbrechung der Klebelinie erreicht.

Figur 13 zeigt eine Draufsicht auf einen Abschnitt des Kontaktelements 40. Dabei ist der Klebstoff 50 punktuell oder entlang einer durchbrochenen Linie aufgebracht, um eine stabile Verbindung zwischen dem Kontaktelement 40 und der Elektrodenfläche 12, 13 des Flächenleuchtelements zu ermöglichen.

Die in Figur 12 in einer Explosionsansicht dargestellten Elemente des Leuchtmoduls können durch Lamination zu einem Verbund, der das Leuchtmodul 1 bildet, gefügt werden. Dabei kann eine Plattenlamination oder eine Rollenlamination verwendet werden, wie noch ausführlicher beschrieben wird. Bei dem Leuchtmodul 1 kann das Kontaktierungselement 40 zur Lamination separat eingelegt und ausgerichtet werden.

Figur 14 zeigt ein Leuchtmodul 1 nach einem Ausführungsbeispiel in einer Explosionsdarstellung im Querschnitt. Auch wenn in Figur 14 nur ein Flächenleuchtelement mit einem Trägersubstrat 10, einer aktiven Schicht 12, einer Verkapselung 11 und Elektrodenflächen 13, 14 dargestellt ist, kann das Leuchtmodul 1 mehr als ein Flächenleuchtelement umfassen. Ein Träger 30 für das Leuchtmodul 1 kann durch eine Folie gebildet werden.

Bei dem Leuchtmodul 1 von Figur 14 ist das Verdrahtungsmaterial, das das Kontaktelement 40 bildet, bereits vor Lamination auf der Folie 30 aufgebracht.

Das Kontaktelement 40 kann durch einen Dünnschichtprozess auf der Folie 30 aufgebracht sein. Das Kontaktelement 40 kann durch Sputtern, Bedampfen oder galvanische Prozesse auf der Folie 30 aufgebracht sein.

Das Kontaktelement 40 kann durch einen Dickschichtprozess auf der Folie 30 aufgebracht sein. Das Kontaktelement 40 kann durch Drucken oder Lamination auf der Folie 30 aufgebracht sein.

Wie für Figur 12 beschrieben kann ein leitende Klebstoff 50 zwischen dem Kontaktelement 40 und der Elektrodenfläche 13, 14 des Flächenleuchtelements 2 vorgesehen sein, um zuverlässig eine elektrische Verbindung zwischen dem Kontaktelement 40 und den Elektrodenflächen 13, 14 herzustellen. Der Klebstoff kann ein Klebstoff sein, der im ausgehärteten Zustand eine Restflexibilität bereitstellt. Beispielsweise kann der Klebstoff 50 ein leitfähiger Klebstoff auf Silikonbasis sein. Der Klebstoff 50 kann alternativ oder zusätzlich auch nichtflächig aufgebracht sein, wie dies unter Bezugnahme auf Figur 12 und Figur 13 beschrieben wurde.

Die Folie 30 mit dem daran angebrachten Kontaktelement 40 wird über den Klebstofffilm 31 und den Klebstoff 50 bei der Lamination mit dem Flächenleuchtelement 2 verbunden. Der Klebstofffilm 31 kann flächig auf die Verkapselung 11 und/oder auf die Folie 30 aufgebracht sein.

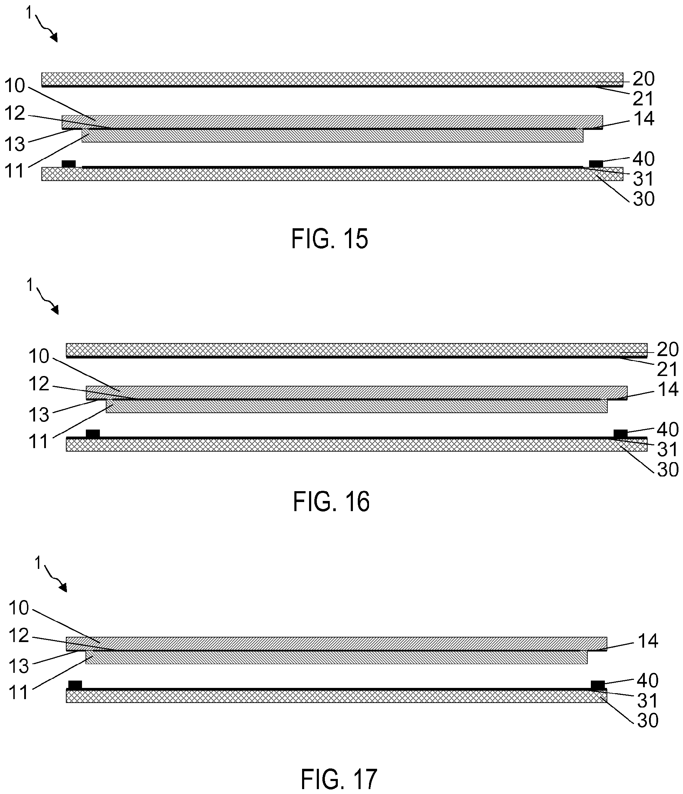

Figur 15 zeigt ein Leuchtmodul 1 nach einem Ausführungsbeispiel in einer Explosionsdarstellung im Querschnitt. Auch wenn in Figur 15 nur ein Flächenleuchtelement mit einem Trägersubstrat 10, einer aktiven Schicht 12, einer Verkapselung 11 und Elektrodenflächen 13, 14 dargestellt ist, kann das Leuchtmodul 1 mehr als ein Flächenleuchtelement umfassen. Ein Träger 30 für das Leuchtmodul 1 kann durch eine Folie gebildet werden.

Bei dem Leuchtmodul 1 von Figur 14 kann das Verdrahtungsmaterial, das das Kontaktelement 40 bildet, bereits vor Lamination auf der Folie 30 aufgebracht sein. Das Kontaktelement 40 kann unmittelbar auf die Folie 30 aufgebracht sein. Das Kontaktelement 40 kann durch einen Dünnschichtprozess auf der Folie 30 aufgebracht sein. Das Kontaktelement 40 kann durch Sputtern, Bedampfen oder galvanische Prozesse auf der Folie 30 aufgebracht sein. Das Kontaktelement 40 kann durch einen Dickschichtprozess auf der Folie 30 aufgebracht sein. Das Kontaktelement 40 kann durch Drucken oder Lamination auf der Folie 30 aufgebracht sein.

Das Leuchtmodul 1 von Figur 15 weist zusätzlich zu den unter Bezugnahme auf Figur 14 beschriebenen Elementen eine Frontfolie 20 auf. Ein Klebstofffilm 21 kann flächig an der Frontfolie 20 vorgesehen sein. Der Klebstofffilm 21 kann auch separat von der Frontfolie 20 zwischen die Frontfolie 20 und das Flächenleuchtelement 2 eingebracht werden. Durch die Frontfolie 20 kann das Leuchtmodul 1 zusätzlich geschützt werden.

Anders als bei Figur 12 und Figur 14 muss bei dem Leuchtmodul 1 von Figur 15 nicht notwendig ein leitender Klebstoff 50 zur elektrischen Verbindung von Kontaktelement 40 und Elektrodenflächen 13, 14 des Flächenleuchtelements 2 vorgesehen sein. Ein derartiger leitender Klebstoff 50 kann jedoch optional verwendet werden.

Die Anordnung der Folien 20, 30 mit den entsprechenden Klebefilmen 21, 31 führt bei der Lamination zur Bildung eines formschlüssigen Verbunds. Die mechanische Verbindung zwischen den Folien 20, 30 und dem Flächenleuchtelement 2 kann über die Klebstofffilme 21, 31 erfolgen. Die elektrische Verbindung des Verdrahtungsmaterials 40 kann rein mechanisch durch den Druck erfolgen, mit dem das Verdrahtungsmaterial 40 bei der Lamination an die Anodenfläche 13 und die Kathodenflächen 14 des Flächenleuchtelements gefügt wird. Die Folien 20, 30 umschließen im Leuchtmodul 1 die Fügefläche zwischen dem Kontaktelement 40 und den Elektrodenflächen 13, 14 und schützen diese gegen Umwelteinflüsse.

Figur 16 zeigt ein Leuchtmodul 1 nach einem Ausführungsbeispiel in einer Explosionsdarstellung im Querschnitt. Auch wenn in Figur 16 nur ein Flächenleuchtelement mit einem Trägersubstrat 10, einer aktiven Schicht 12, einer Verkapselung 11 und Elektrodenflächen 13, 14 dargestellt ist, kann das Leuchtmodul 1 mehr als ein Flächenleuchtelement umfassen. Ein Träger 30 für das Leuchtmodul 1 kann durch eine Folie gebildet werden.

Bei dem Leuchtmodul 1 von Figur 16 kann ein Klebstofffilm 31 flächig auf der Folie 30 angeordnet sein. Um das Kontaktelement zu bilden, kann ein Verdrahtungsmaterial 40 auf den Klebstofffilm 31 aufgebracht werden. Das Verdrahtungsmaterial 40 kann beispielsweise aus einer leitfähigen Tinte oder Paste bestehen.

Das Verdrahtungsmaterial 40 kann konditioniert werden, um das Kontaktelement zu bilden. Dies kann vor der Lamination der Folie(n) 20, 30 mit dem Flächenleuchtelement 2 erfolgen. Zum Konditionieren des Verdrahtungsmaterials 40 kann dieses getempert oder anderweitig behandelt werden, um das Verdrahtungsmaterial 40 auszuhärten.

Der Klebstofffilm 31 kann aus einem thermisch aktivierbaren Material ausgebildet sein. Der Klebstofffilm 31 kann aus einem Material sein, das bei Raumtemperatur nichtklebend ist. Dies erlaubt, das elektrisch leitfähige Verdrahtungsmaterial 40 beispielsweise durch Siebdruck, Flexodruck oder ein anderes Kontaktdruckverfahren aufbringen zu können. Alternativ kann auch ein kontaktfreies Druckverfahren verwendet werden, beispielsweise ein so genannter Inkjetdruck.

Zum Herstellen des Leuchtmoduls 1 können die in Figur 16 dargestellten Komponenten mittels eines Laminationsprozesses gefügt werden. Die Verklebung der Frontfolie 20 mit der Folie 30 kann formschlüssig erfolgen. Die elektrische Verbindung des Verdrahtungsmaterials 40 kann rein mechanisch durch den Druck erfolgen, mit dem das Verdrahtungsmaterial 40 bei der Lamination an die Anodenfläche 13 und die Kathodenflächen 14 des Flächenleuchtelements gefügt wird. Die Folien 20, 30 umschließen im Leuchtmodul 1 die Fügefläche zwischen dem Verdrahtungsmaterial 40 und den Elektrodenflächen 13, 14 und schützen diese gegen Umwelteinflüsse.

Bei einem Leuchtmodul 1 nach einem weiteren Ausführungsbeispiel wird ein Aufbau verwendet, wie er allgemein in Figur 16 dargestellt ist. Allerdings wird das Verdrahtungsmaterial 40 nicht vor dem Laminieren konditioniert. Das Verdrahtungsmaterial 40 kann beim Laminationsprozess konditioniert werden, so dass es aushärtet. Dies kann beispielsweise durch einen Wärmeeintrag in das Verdrahtungsmaterial 40 erfolgen.

Bei dieser Ausgestaltung kann die Kontaktfläche zwischen dem Verdrahtungsmaterial 40 und den Elektrodenflächen 13, 14 des Flächenleuchtelements 2 nicht nur durch die Folien 20, 30, sondern auch durch das Verdrahtungsmaterial 40 selbst verklebt und somit eingekapselt werden. Die Stabilität der elektrischen Verbindung kann auf diese Weise erhöht werden.

Figur 17 zeigt ein Leuchtmodul 1 nach einem Ausführungsbeispiel in einer Explosionsdarstellung im Querschnitt. Auch wenn in Figur 17 nur ein Flächenleuchtelement mit einem Trägersubstrat 10, einer aktiven Schicht 12, einer Verkapselung 11 und Elektrodenflächen 13, 14 dargestellt ist, kann das Leuchtmodul 1 mehr als ein Flächenleuchtelement umfassen. Ein Träger 30 für das Leuchtmodul 1 kann durch eine Folie gebildet werden.

Bei dem Leuchtmodul 1 von Figur 17 kann ein Klebstofffilm 31 flächig auf der Folie 30 angeordnet sein. Um das Kontaktelement zu bilden, kann ein Verdrahtungsmaterial 40 auf den Klebstofffilm 31 aufgebracht werden. Das Verdrahtungsmaterial 40 kann beispielsweise aus einer leitfähigen Tinte oder Paste bestehen.

Das Verdrahtungsmaterial 40 kann während der Lamination konditioniert werden, um das Kontaktelement zu bilden. Zum Konditionieren des Verdrahtungsmaterials 40 kann dieses getempert oder anderweitig behandelt werden, um das Verdrahtungsmaterial 40 auszuhärten. Das Verdrahtungsmaterial 40 kann beim Laminationsprozess konditioniert werden, so dass es aushärtet. Dies kann beispielsweise durch einen Wärmeeintrag in das Verdrahtungsmaterial 40 während der Lamination erfolgen.

Der Klebstofffilm 31 kann aus einem thermisch aktivierbaren Material ausgebildet sein. Der Klebstofffilm 31 kann aus einem Material sein, das bei Raumtemperatur nichtklebend ist. Dies erlaubt, das elektrisch leitfähige Verdrahtungsmaterial 40 beispielsweise durch Siebdruck, Flexodruck oder ein anderes Kontaktdruckverfahren aufbringen zu können. Alternativ kann auch ein kontaktfreies Druckverfahren verwendet werden, beispielsweise ein so genannter Inkjetdruck.

Zum Herstellen des Leuchtmoduls 1 können die in Figur 17 dargestellten Komponenten mittels eines Laminationsprozesses gefügt werden. Beim Laminationsprozess erfolgt sowohl die mechanische Verbindung zwischen der Folie 30 und dem Flächenleuchtelement 2 als auch die elektrische Anbindung des Kontaktelements, das durch Wärmeeintrag in das Verdrahtungsmaterial 40 gebildet wird.

Bei den Leuchtmodulen 1, die unter Bezugnahme auf Figur 10 bis Figur 17 detailliert beschrieben wurden, können Funktionsbeschichtungen, Blenden oder andere zusätzliche Schichten in den Verbundkörper integriert sein, wie unter Bezugnahme auf Figur 1 bis Figur 9 beschrieben wurde.

Bei den Leuchtmodulen 1 nach den verschiedenen Ausführungsbeispielen kann die Herstellung einen Laminationsprozess umfassen. Die Folie 30 oder die Folien 20, 30 werden mit dem Flächenleuchtelement 2 so zusammengefügt, dass das Kontaktierungselement 40 zwischen wenigstens einer Folie 30 und dem Flächenleuchtelement 2 vorgesehen ist.

Das Leuchtmodul 1 kann durch eine Plattenlamination gebildet werden. Die Komponenten des Leuchtmoduls können auf eine beheizbare Platte eines Plattenlaminators gelegt werden. Durch Verringerung des Drucks zwischen den Platten des Plattenlaminators kann der Verbund durch den Atmosphärendruck zusammengedrückt werden. Die beheizbare Platte kann dabei temperiert werden. Dadurch kann eine thermische Aktivierung oder ein Aufschmelzen des Klebstoffes 21, 31, 50 hervorgerufen werden, der den Verbund verschmelzen lässt.

Bei der Plattenlamination können auch längere Temperaturkurven gefahren werden, wobei der Druck in kontrollierter Weise gesteuert werden kann.

Das Leuchtmodul 1 kann durch Rollenlamination gebildet werden. Der Laminationsprozess erfolgt zwischen mindestens zwei Rollen, die beheizt werden und durch Druck einen Verbund bilden. Hierbei ist es möglich die Frontfolie 20 und die Rückfolie 30 von einer Rolle zuzuführen. Es können auch zusätzliche Folien, beispielsweise das Verdrahtungsmaterial, ein Auskoppelsystem und/oder ein oder mehrere Klebefilme 21, 31 von Rollen zugeführt werden.

Die Flächenleuchtelemente, die OLED-Panels oder QLED-Panels sein können, können nacheinander zwischen die Folien 20, 30 eingelegt und einlaminiert werden. Ein derartiger Prozess ermöglicht die Herstellung von Leuchtmodulen mit großen Längen. Beispielsweise sind Rollenlänge von ca. 100 m und mehr möglich.

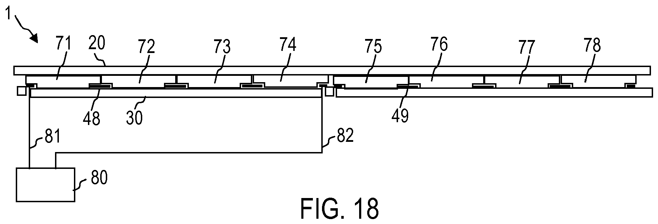

Figur 18 zeigt eine Leuchte mit einem Leuchtmodul 1 nach einem Ausführungsbeispiel und einem Konverter 80. Das Leuchtmodul 1 umfasst mehrere Reihenschaltungen von Flächenleuchtelementen. Eine erste Reihenschaltung mit Flächenleuchtelementen 71-74 wird hergestellt, indem ein erster Abschnitt 48 des Kontaktierungselements jeweils Kathodenkontakte und Anodenkontakte benachbarter Flächenleuchtelementen 71-74 miteinander verbindet. Der erste Abschnitt 48 des Kontaktierungselements kann auch den Anschluss von Verbindungsleitungen 81, 82, beispielsweise durch Steckverbindungen, Klemmverbindungen, Lötverbindungen oder Klebverbindungen erlauben. Der erste Abschnitt 81 kann entsprechend Kopplungselemente zum Herstellen einer Steckverbindung oder Klemmverbindung aufweisen.

Eine erste Reihenschaltung mit Flächenleuchtelementen 75-78 wird erzeugt, indem ein zweiter Abschnitt 49 des Kontaktierungselements jeweils Kathodenkontakte und Anodenkontakte benachbarter Flächenleuchtelementen 75-78 miteinander verbindet. Der zweite Abschnitt 49 des Kontaktierungselements kann auch den Anschluss von nicht dargestellten Verbindungsleitungen, beispielsweise durch Steckverbindungen, Klemmverbindungen, Lötverbindungen oder Klebverbindungen, erlauben. Der zweite Abschnitt 82 kann entsprechend Kopplungselemente zum Herstellen einer Steckverbindung oder Klemmverbindung aufweisen.

Die Flächenleuchtelemente, die bei Leuchtmodulen nach Ausführungsbeispielen verwendet werden, können OLED-Panels sein. Die Flächenleuchtelemente, die bei Leuchtmodulen nach Ausführungsbeispielen verwendet werden, können QLED-Panels sein. Es können auch OLED-Panels und QLED-Panels in einem Leuchtmodul kombiniert werden.

Es ist möglich, zusätzliche Funktionsschichten oder Elemente in das Leuchtmodul zu integrieren. Beispielsweise können gefärbte Folien eingesetzt werden, um gewünschte Lichtmuster oder Farbmuster zu erzeugen.

Während eine Herstellung des Leuchtmoduls in Kontext einer Plattenlamination oder einer Rollenlamination beschrieben wurde, können auch andere Laminationsverfahren eingesetzt werden.

Die Leuchtmodule nach Ausführungsbeispielen können flexible Leuchtmodule sein. Die beschriebenen Verfahren und Vorrichtungen erlauben die Verarbeitung von Flächenleuchtelementen durch Leuchtenhersteller. Die Leuchtmodule können zur Verwendung in Leuchten zur diffusen Raumbeleuchtung eingerichtet sein.

Vorrichtungen und Verfahren nach Ausführungsbeispielen können insbesondere für den Betrieb von Leuchtmitteln, die LEDs umfassen, eingesetzt werden.

## Patentansprüche

1. Leuchtmodul mit einem mehrlagigen Aufbau, umfassend:
mehrere Flächenleuchtelemente (2; 71-78), die ausgewählt sind aus einer Gruppe bestehend aus einem OLED-Flächenleuchtelement und einem QLED-Flächenleuchtelement,
ein Kontaktierungselement (40; 48, 49), das leitende Strukturen aufweist,
eine Folie (30), die flächig an den Flächenleuchtelementen (2; 71-78) angebracht ist, so dass wenigstens ein Abschnitt des Kontaktierungselements (40; 48, 49) zwischen der Folie (30) und den Flächenleuchtelementen (2; 71-78) angeordnet ist, und
eine weitere Folie (20), die flächig an den Flächenleuchtelementen (2; 71-78) angebracht ist, so dass die Flächenleuchtelemente (2; 71-78) zwischen der weiteren Folie und dem Kontaktierungselement (40; 48, 49) angeordnet sind,
**dadurch gekennzeichnet,**
**dass** das Kontaktierungselement (40; 48, 49) eingerichtet ist, um die mehreren Flächenleuchtelemente (2; 71-78), die zwischen der Folie (30) und der weiteren Folie (20) angeordnet sind, in eine Mehrzahl von Reihenschaltungen zu verbinden.

2. Leuchtmodul nach Anspruch 1,
wobei die Folie (30) und/oder die weitere Folie (20) wenigstens eine Funktionsbeschichtung (23, 33) aufweist,
wobei die wenigstens eine Funktionsbeschichtung (23, 33) ausgewählt ist aus einer Gruppe bestehend aus einer Kratzschutzbeschichtung, einer Antireflexbeschichtung, einer Wärmeleitschicht und einer Schicht zur Verbesserung einer optischen Auskopplung.

3. Leuchtmodul nach Anspruch 1 oder Anspruch 2,
wobei die Folie (30) und/oder die weitere Folie (20) eine Öffnung (32) oder mehrere Öffnungen (32) zum Kontaktieren des Flächenleuchtelements (2; 71-78) aufweist.

4. Leuchtmodul nach einem der Ansprüche 1 bis 3,
wobei das Kontaktierungselement (40) zum Anschließen wenigstens eines elektrisch leitenden Verbindungselements seitlich über die Folie (30) hervorragt.

5. Leuchtmodul nach einem der Ansprüche 1 bis 4,
wobei jede der Reihenschaltungen aus einer Anzahl von Flächenleuchtelementen (2; 71-78) besteht, die so gewählt ist, dass eine Vorwärtsspannung jeder der Reihenschaltungen kleiner als 75 Volt DC ist.

6. Leuchtmodul nach einem der vorhergehenden Ansprüche, umfassend
wenigstens eine Abdeckschicht (60) zum Abdecken nicht Licht emittierender Bereiche des Leuchtmoduls (1), wobei die Abdeckschicht (60) gebildet ist durch:
eine Zusatzfolie (60), die zwischen die weitere Folie (20) und ein Trägersubstrat (10) der Flächenleuchtelemente eingelegt ist und die in einem Bereich einer Lichtemission (12) transparent oder freigestellt und im restlichen Bereich blickdicht oder lichtdicht ist, und/oder
eine lichtdichte Bedruckung der weiteren Folie (20) auf einer Frontseite und/oder Rückseite, wobei die lichtdichte Bedruckung selektiv in denjenigen Bereichen vorhanden ist, die nicht Licht emittierende Bereiche des Flächenleuchtelements (2) überdecken.

7. Leuchtmodul nach einem der vorhergehenden Ansprüche,
wobei die Flächenleuchtelemente (2; 71-78) ein Trägersubstrat (10), eine aktive lichtemittierende Schicht (12), die als OLED oder QLED-Struktur ausgebildet ist, und eine Verkapselung (11) umfassen, wobei die aktive lichtemittierende Schicht (12) zwischen dem Trägersubstrat (10) und der Verkapselung (11) angeordnet ist.

8. Leuchtmodul nach einem der vorhergehenden Ansprüche,
wobei die Flächenleuchtelemente (2; 71-78) eine Elektrodenfläche (13, 14) umfassen,
wobei das Kontaktierungselement (40; 48, 49) mit einem elektrisch leitenden Klebstoff (50) mit der Elektrodenfläche (13, 14) verbunden ist.

9. Leuchtmodul nach einem der Ansprüche 1 bis 8,
wobei das Kontaktierungselement (40; 48, 49) auf einem auf der Folie (30) vorgesehenen flächigen Klebstofffilm (31) aufgebracht ist.

10. Leuchte, umfassend
ein Leuchtmodul (1) nach einem der vorhergehenden Ansprüche und einen Konverter (80).

11. Leuchte nach Anspruch 10,
wobei ein Ausgang des Konverters (80) elektrisch leitend mit wenigstens einer Leitungsstruktur (48, 49) des Verdrahtungsträgers (40; 48, 49) verbunden ist.

12. Verfahren zur Herstellung eines Leuchtmoduls nach einem der Ansprüche 1 bis 9, umfassend
Laminieren der Folie (30) an mehrere Flächenleuchtelemente (2; 71-78), die ein OLED-Flächenleuchtelement (2; 71-78) oder ein QLED-Flächenleuchtelement (2; 71-78) sind,
wobei die Folie (30) so an die Flächenleuchtelemente (2; 71-78) laminiert wird, dass wenigstens ein Abschnitt des Kontaktierungselements (40; 48, 49) zwischen der Folie (30) und den Flächenleuchtelementen (2; 71-78) angeordnet ist,
wobei das Leuchtmodul (1) eine weitere Folie (20) umfasst, und
wobei die Flächenleuchtelemente (2; 71-78) durch einen Plattenlaminationsprozess oder einen Rollenlaminationsprozess zwischen die Folie (30) und die weitere Folie (20) einlaminiert werden.

## Claims

1. Lighting module having a multilayered structure, including:
a plurality of planar lighting elements (2; 71-78) which are selected from a group consisting of an OLED planar lighting element and a QLED planar lighting element,
a contact element (40; 48, 49), which has conductive structures,
a film (30), which is applied flat to the planar lighting elements (2; 71-78) so that at least one section of the contact element (40; 48, 49) is arranged between the film (30) and the planar lighting elements (2; 71-78), and
an further film (20), which is applied flat to the planar lighting elements (2; 71-78) so that the planar lighting elements (2; 71-78) are arranged between the further film and the contact element (40; 48, 49),
**characterized in that**
the contact element (40; 48, 49) is configured to connect the plurality of planar lighting elements (2; 71-78), which are arranged between the film (30) and the further film (20), into a plurality of series circuits.

2. Lighting module according to Claim 1,
wherein the film (30) and/or the further film (20) have at least one functional coating (23, 33),
wherein the at least one functional coating (23, 33) is selected from a group consisting of a scratch-protection coating, an antireflective coating, a heat-conducting layer and a layer for improving optical decoupling.

3. Lighting module according to Claim 1 or Claim 2,
wherein the film (30) and/or the further film (20) has an opening (32) or a plurality of openings (32) for bringing the planar lighting element (2; 71-78) into contact.

4. Lighting module according to any one of Claims 1 to 3,
wherein the contact element (40) projects laterally beyond the film (30) in order to connect at least one electrically conductive connecting element.

5. Lighting module according to any one of Claims 1 to 4,
wherein each of the series circuits consists of a number of planar lighting elements (2; 71-78), which is selected such that a forward voltage of each of the series circuits is less than 75 volts DC.

6. Lighting module according to any one of the preceding Claims, comprising
at least one cover layer (60) for covering non-light-emitting regions of the lighting module (1), wherein the cover layer (60) is formed by:
an additional film (60), which is inserted between the further film (20) and a carrier substrate (10) of the planar lighting elements and is transparent or free in a region of a light emission (12) and opaque or light-tight in the remaining region, and/or
a light-tight printing of the further film (20) on a front side and/or rear side, wherein the light-tight printing is selectively present in those regions that cover non-light-emitting regions of the planar lighting element (2).

7. Lighting module according to any one of the preceding Claims,
wherein the planar lighting elements (2; 71-78) include a carrier substrate (10), an active light-emitting layer (12), which is configured as an OLED or QLED structure, and an encapsulation (11), wherein the active light-emitting layer (12) is arranged between the carrier substrate (10) and the encapsulation (11).

8. Lighting module according to any one of the preceding Claims,
wherein the planar lighting elements (2; 71-78) include an electrode surface (13, 14),
wherein the contact element (40; 48, 49) is connected to the electrode surface (13, 14) by means of an electrically conductive adhesive (50).

9. Lighting module according to any one of Claims 1 to 8,
wherein the contact element (40; 48, 49) is applied to a planar adhesive film (31) provided on the film (30).

10. Lamp, including
a lighting module (1) according to any one of the preceding Claims and
a converter (80).

11. Lamp according to Claim 10,
wherein an output of the converter (80) is electrically conductively connected to at least one conducting structure (48, 49) of the circuit board (40; 48, 49).

12. Method for producing a lighting module according to any one of Claims 1 to 9, including
laminating the film (30) onto a plurality of planar lighting elements (2; 71-78), which are an OLED planar lighting element (2; 71-78) or a QLED planar lighting element (2; 71-78),
wherein the film (30) is laminated onto the planar lighting elements (2; 71-78) in such a way that at least one section of the contact element (40; 48, 49) is arranged between the film (30) and the planar lighting elements (2; 71-78),
wherein the lighting module (1) includes a further film (20), and
wherein the planar lighting elements (2; 71-78) are laminated in between the film (30) and the further film (20) by means of a plate lamination process or a roll lamination process.

## Revendications

1. Module d'éclairage doté d'une structure en couches multiples, comprenant :
plusieurs éléments d'éclairage de surface (2 ; 71 à 78), qui sont choisis dans un groupe constitué d'un élément d'éclairage de surface à OLED et d'un élément d'éclairage de surface à QLED,
un élément de contact (40 ; 48, 49), qui présente des structures conductrices,
un film (30), qui est apposé à plat sur les éléments d'éclairage de surface (2 ; 71 à 78) de sorte qu'au moins une section de l'élément de contact (40; 48, 49) est disposée entre le film (30) et les éléments d'éclairage de surface (2 ; 71 à 78), et
un nouveau film (20), qui est apposé à plat sur les éléments d'éclairage de surface (2 ; 71 à 78) de sorte que les éléments d'éclairage de surface (2 ; 71 à 78) sont disposés entre le nouveau film et l'élément de contact (40 ; 48, 49),
**caractérisé en ce**
**que** l'élément de contact (40 ; 48,49) est conçu pour relier les nombreux éléments d'éclairage de surface (2 ; 71 à 78), qui sont disposés entre le film (30) et le nouveau film (20), pour constituer une multiplicité de circuits en série.

2. Module d'éclairage selon la revendication 1,
dans lequel le film (30) et/ou le nouveau film (20) présentent au moins un revêtement fonctionnel (23, 33), où l'au moins un revêtement fonctionnel (23, 33) est choisi dans le groupe constitué d'un revêtement de protection contre les rayures, un revêtement antireflet, une couche conductrice thermique et une couche destinée à l'amélioration d'un découplage optique.

3. Module d'éclairage selon la revendication 1 ou la revendication 2,
dans lequel le film (30) et/ou le nouveau film (20) présentent un orifice (32) ou plusieurs orifices (32) pour le contact de l'élément d'éclairage de surface (2 ; 71 à 78) .

4. Module d'éclairage selon l'une des revendications 1 à 3, dans lequel l'élément de contact (40) dépasse latéralement par-dessus le film (30) pour une connexion d'au moins un élément de connexion électriquement conducteur.

5. Module d'éclairage selon l'une des revendications 1 à 4, dans lequel chacun des circuits en série est constitué d'un certain nombre d'éléments d'éclairage de surface (2 ; 71 à 78) qui sont choisis de telle manière qu'une tension directe de chacun des circuits en série est inférieure à 75 Volt CC.

6. Module d'éclairage selon l'une des revendications précédentes, comprenant
au moins une couche de recouvrement (60) destinée au recouvrement de régions n'émettant pas de lumière du module d'éclairage (1), la couche de recouvrement (60) étant formée par :
un film complémentaire (60), qui est entreposé entre le nouveau film (20) et un substrat de support (10) des éléments d'éclairage de surface et qui est transparent ou exposé librement dans une région d'émission de lumière (12) et est opaque ou imperméable à la lumière dans la zone restante, et/ou
une impression imperméable à la lumière du nouveau film (20) sur une face avant et/ou une face arrière, où l'impression imperméable à la lumière est présente de manière sélective dans les régions qui recouvrent des régions de l'élément d'éclairage de surface (2) n'émettant pas de lumière.

7. Module d'éclairage selon l'une des revendications précédentes,
dans lequel les éléments d'éclairage de surface (2 ; 71 à 78) comprennent un substrat de support (10), une couche (12) émettrice de lumière active qui est conçue sous forme d'une structure à OLED ou à QLED, et un encapsulage (11), où la couche (12) émettrice de lumière active est disposée entre le substrat de support (10) et l'encapsulage (11).

8. Module d'éclairage selon l'une des revendications précédentes,
dans lequel les éléments d'éclairage de surface (2 ; 71 à 78) comprennent une surface d'électrode (13, 14),
dans lequel l'élément de contact (40 ; 48, 49) est relié par un adhésif (50) conducteur électrique avec la surface d'électrode (13, 14).

9. Module d'éclairage selon l'une des revendications 1 à 8, dans lequel l'élément de contact (40 ; 48, 49) est rapporté sur un film d'adhésif (31) plat prévu sur le film (30).

10. Luminaire, comprenant
un module d'éclairage (1) selon l'une des revendications précédentes et
un convertisseur (80).

11. Luminaire selon la revendication 10,
dans lequel une sortie du convertisseur (80) est reliée, de manière électriquement conductrice avec au moins une structure en ligne (48, 49) du support de câblage (40 ; 48, 49) .

12. Procédé de fabrication d'un module d'éclairages selon l'une des revendications 1 à 9, comprenant un laminage du film (30) sur plusieurs éléments d'éclairage de surface (2 ; 71 à 78), qui sont un élément d'éclairage de surface à OLED (2 ; 71 à 78) ou un élément d'éclairage de surface à QLED (2 ; 71 à 78),
où le film (30) est laminé sur les éléments d'éclairage de surface (2 ; 71 à 78) de sorte qu'au moins une section de l'élément de contact (40 ; 48, 49) est disposée entre le film (30) et les éléments d'éclairage de surface (2 ; 71 à 78),
où le module d'éclairage (1) comprend un nouveau film (20), et
où les éléments d'éclairage de surface (2 ; 71 à 78) sont laminés par un procédé de laminage par plaques ou un procédé de laminage par rouleaux entre le film (30) et le nouveau film (20).
